**Europäisches Patentamt**

(19) **European Patent Office**

**Office européen des brevets**

(11) Publication number: **0 096 218**
**B1**

(12) EUROPEAN PATENT SPECIFICATION

(45) Date of publication of patent specification: **16.08.90**

(51) Int. Cl.⁵: **H 01 L 29/82**

(21) Application number: **83104290.8**

(22) Date of filing: **02.05.83**

(54) **Differentially magnetically sensitive diode structure**

(30) Priority: **15.06.82 US 388773**

(43) Date of publication of application:
**21.12.83 Bulletin 83/51**

(45) Publication of the grant of the patent:
**16.08.90 Bulletin 90/33**

(84) Designated Contracting States:
**DE FR GB**

(56) References cited:
**EP-A-0 006 983**
**EP-A-0 063 209**

**ELECTRONICS INTERNATIONAL, vol. 55, no. 10, 19th May 1982, pages 45,46, New York, US; R. BERESFORD: "Magnetic transistors exploit new theory of carrier modulation"**

(73) Proprietor: **International Business Machines Corporation**
**Old Orchard Road**
**Armonk, N.Y. 10504 (US)**

(72) Inventor: **Vinal, Albert Watson**
**810 Queensferry Rd.**
**Cary, NC 27511 (US)**

(74) Representative: **Siccardi, Louis**
**Compagnie IBM France Département de Propriété Intellectuelle**
**F-06610 La Gaude (FR)**

Courier Press, Leamington Spa, England.

## Description

Field of the Invention

The invention relates to diode structures.

Prior Art

A number of magnetically sensitive transistor structures have been previously described in the prior art. Examples are U.S. patents 3,389,230, 3,533,159 or 3,692,595. Other similar art is also known but does not differ greatly from these patents. The general description that fits these prior art devices is that an elongated emitter is centrally located between two laterally spaced elongated collectors, with major portions of the collectors being on opposite sides of the emitter and some portions below and parallel to it.

A chief difficulty with the known prior art lies in the fact that these transistor devices presume the magnetic transduction mechanism to be the deflection of electrons or of injected carriers by a magnetic field. According to this belief, the carriers are diverted to and collected more heavily at one collector than the other. The structure using the deflection theory employs an elongated emitter with two parallelly spaced collectors straddling the emitter on each side. This makes the long axis of the emitter and the collectors parallel with the magnetic field vector to which the device is sensitive. In adopting such a configuration, the developers thereof failed to recognize or utilize the newly discovered transduction mechanisms first described in EP—A—63209.

Magnetically sensitive transistors also require contacts for the collectors and the added complication of constructing collector members themselves. To simplify the design and eliminate sources of signal-reducing carrier recombination, etc., it would be greatly desirable to simplify structures further and yet achieve a magnetically sensitive device. A minimum of components or elements in the structure also should enhance the yield of the manufacturing processes employed.

Objects of the Invention

In view of the known difficulties with the prior art, an object of the present invention is to provide an improved magnetically sensitive diode structure requiring only an emitter and two base contacts to take advantage of the Lorentz field modulation of emitter carrier injection.

A further object of the present invention is to provide an improved differentially magnetically sensitive diode structure.

Still a further object of the present invention is to provide an improved magnetically sensitive diode structure with means for limiting or controlling the dominant area of carrier injection from the emitter surfaces to a specified smaller portion of the total emitter base junction area.

Summary

As described below, the foregoing objects of the present invention are met by a magnetically sensitive, differential diode structure according to claim 1.

The invention will be further described with reference to a typical preferred embodiment and illustrative drawings as follows:

Brief Description of Drawings

Figure 1 illustrates a schematic plan view of a preferred embodiment of a differentially sensitive magnetic diode constructed in accordance with the principles of the present invention and showing schematically its mode of employment for sensing an output signal.

Figure 2 is a cross-sectional view taken longitudinally through the conducting base of the differential diode structure shown in Figure 1.

Figure 3 is another cross-sectional view of the device shown in Figure 1 taken at right angles to the cross-sectional view depicted in Figure 2.

Detailed Specification

As has been previously described in EP—A—63209 a new primary transduction mechanism has been identified that is responsible for the magnetic sensitivity of a variety of magnetic transistors. It was previously unknown, however, that the same mechanism can be made operative in diode structures. It has been discovered that by utilizing relatively longer base lengths and controlling emitter injection to occur preferentially from a single surface of the emitter, one can achieve operative differentially sensitive diodes. The transduction mechanism has been identified as Lorentz field induced modulation of injection of carriers at the emitter. Simply put, this will now be called Lorentz modulation of injection.

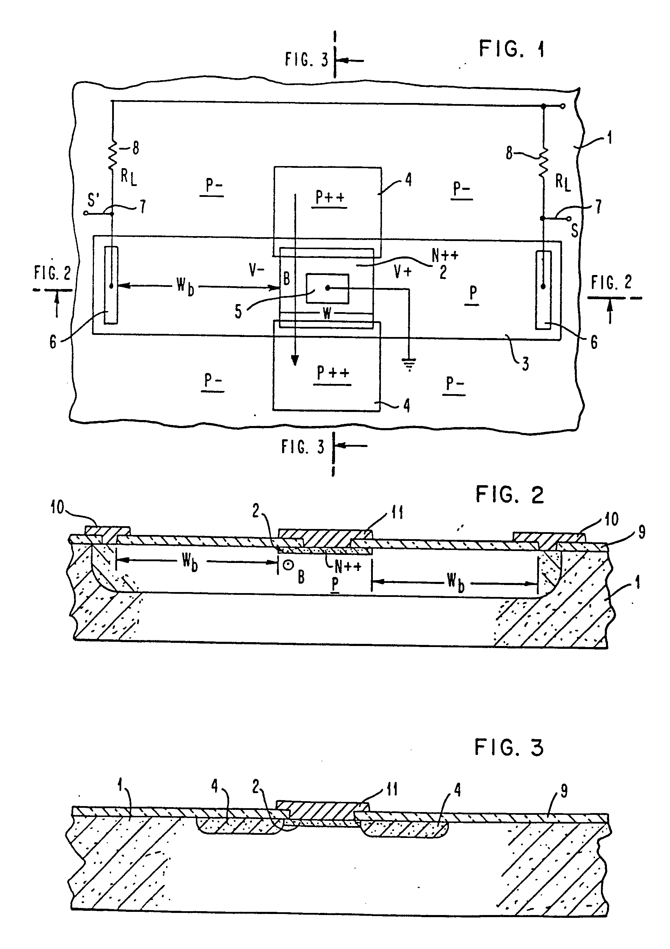

Turning to Figure 1, a structure of a typical differentially sensitive magnetic diode of the preferred form of the present invention is shown. It should be understood that the substrate 1 in Figure 1 is a silicon wafer or chip and that the plan view of the elements in Figure 1 omits depicting the surrounding material except by the usage of the P- symbols showing the generally surrounding substrate area to be a lightly doped P type substrate material. An emitter 2 of heavily N type doped material is shown centrally located in an elongated base 3 comprising P type material more heavily doped than the surrounding substrate. Very heavily doped P type injection suppressor areas 4 form boundaries to the side of the emitter 2 to inhibit injection into the substrate there and enhance injection from the bottom of the emitter 2. A contact 5 is shown for the emitter 2 and is depicted as simply a rectangular area, it being understood that an overlying layer of silicon dioxide insulator and metallic contact have been omitted in Figure 1 for clarity. Base contact areas 6 are also shown at either end of the elongated common region 3. These are not implants, but are merely areas to which ohmic contact with the surface of the semiconductive material substrate may be made. Signal leads 7 and load resistances 8 are used to derive the output signal $V_{bb}$ which is the base to base output voltage relative to ground. The emitter 2 is grounded through its contact 5 as schematically shown.

In Figure 2, a horizontal elevational cross section taken along line AA in Figure 1 is illustrated. The substrate 1 is now shown with an overlying silicon dioxide layer 9 and with metallic base contacts 10 and a metallic emitter contact 11 included. Due to the location of the sectional line in Figure 1, the heavily doped P+ suppressor pockets 4 do not appear in Figure 2. The length of the base region 3 is measured from the edges of the emitter 2 and is depicted as $W_b$ as shown in Figure 2. The base region 3 comprises a pocket of implanted heavily doped P type material diffused or implanted into the surface of the substrate 1 using well known techniques. The emitter 2 is an N type heavily doped implanted region to which ohmic contact by contact 11 is made as shown. Injection from the emitter 2 will be primarily in the direction vertically out the bottom surface of the emitter 2 or downward in the case of Figure 2. A magnetic field vector B is depicted in Figures 1 and 2 as an arrow or as a circle and dot using the normal convention for magnetic field vectors.

The structure depicted in the figures is thus a vertically injecting device and is sensitive to magnetic field vectors B oriented generally parallel to the substrate and perpendicular to the general direction of injection of carriers from the emitter.

Devices such as that depicted are constructed using relatively high resistivity substrate material, typically in the range of 100 ohm centimeters. A low resistivity of approximately .2 ohm centimeter P type doped base region 3 is first diffused in the substrate 1. The depth of the region is typically 50,000 Angstroms (5 microns) in preferred forms of the embodiment shown. Separate base contacts 10 as shown in Figure 2 are made at each end of the base region 3. Next, a shallow emitter region 2 is formed using a material of opposite type to that used in the base. As depicted, this region is heavily doped N type material approximately 5000 angstroms (.5 microns) and it typically consists of arsenic doping if the base region 3 is doped to form a P type material. The bottom surface of emitter 2 will be the dominant injecting region. This is assured by the heavily doped P+ type implant regions 4 shown in Figure 1. The bottom surface of emitter 2 supplies minority carriers by injection into and conduction through the base to both base contact regions at opposite ends of the base channel 3.

The regions 4 shown in Figure 1 prevent injection from occurring along the edges of emitter diffusion 2. These are preferred since, if the edges of emitter 2 were to contact the high resistivity region of the substrate 1, some excessive minority carrier injection could occur in a direction not perpendicular to the magnetic field. This would partially reduce the signal output and would also desensitize the magnetic diode structure by injecting carriers into the P− substrate region which would be shunted around the P+ base 3 and conducted out by the base contacts 10.

The vertically injected portion of the emitter current will be modulated by a Lorentz potential $V_L$ developed across the longest axis of the emitter-base junction. A differential current and voltage will be experienced at the base contacts which obeys the following general relationship.

$$\Delta I_E = I_{EO} \, \mathrm{Sinh}(qV_L/Kt) \tag{1a}$$

$$\Delta E = I_{EO} \, R_b \, \mathrm{Sinh}\,(qV_L/Kt) \tag{1b}$$

where $I_{Eo}$ is the emitter current given a base open configuration.

Equation (1a) shows the differential current relationship and equation (1b) the differential voltage relation experienced at the output terminals. The value of $R_b$ is the resistance of the length of base material 3 between the emitter 2 and the base contacts 10.

The parameter $V_L$ defines the Lorentz injection modulation potential. The potential has been derived previously in my aforementioned application EP—A—63209 but is given again below:

$$V_L \, \max = \frac{VBW}{2KT/q} = \frac{W}{2Ln}(\mu_n B) \, \mathrm{Coth} \, W_n/L_n \tag{2}$$

$$V_L \, \max = \frac{W}{2Wb}(\nu_n B) \, \text{for} \, W_b/L_n < 1$$

$$V_L \, \max = \frac{W}{2Ln}(\mu_n B) \, \text{for} \, W_b/L_n > 1$$

Where:

$\mu_n$ is the carrier mobility

B is magnetic field density

W is width of emitter region

A fundamental expression for the differential current injected at the lower surface of the emitter 2 into the base region 3 of the differential diode structure shown in Figures 1 and 2 is given by expression 3 below.

$$\Delta Ie = Ieo(q/2kt)(VBW) \tag{3}$$

Where $I_{eo}$ is the emitter current through the lower surface of the emitter, given a base open configuration.

The above expression has been previously derived and has only been repeated here for convenience.

An expression for the velocity V of the injected minority carriers is given as follows:

$$V = (Dn/Ln) \operatorname{Coth} (Wb/Ln) = (KTq) (\mu n/Ln)\operatorname{Coth} (Wb/Ln) \tag{4}$$

By substituting equation (4) into equation (3), one can derive an expression for the change in emitter current.

$$\Delta Ie = Ieo \, W/Ln \, (\mu B/2) \operatorname{Coth} Wb/Ln \tag{5}$$

For short base diodes in which the length Wb is less than a diffusion length Ln, Equation (5) reduces to the following.

$$\Delta Ie = W/WB \, (\mu n B/2) \tag{6}$$

For long base diodes where the base length Wb is greater than a diffusion length Ln, equation (5) reduces to another expression:

$$\Delta Ie = Ieo \, W/Ln \, (\mu B/2) \tag{7}$$

A differential output voltage can be measured between the base contacts 10 depending upon the resistivity of the base channels between the emitter surface and each base output contact, Rb. This is given by the following expression:

$$\Delta V = Ieo \, W/Ln \, (\mu n B/2)Rb \operatorname{Coth} Wb/Ln \tag{8}$$

Where:

Rb = ρ Wb/W Tb

ρ = resistivity of base channel

Wb = base length

W = emitter width

Tb = depth of base channel

The resistivity ρ of the base channel in the area close to the emitter-base junction is determined primarily by the concentration of excess minority carriers injected into that region. As one approaches the vicinity of the base contact, the resistivity is determined as follows:

$$\rho = 1/Naq\mu \quad p = 1/\sigma \tag{9}$$

Where:

Na = acceptor concentration in base

q = charge

$\mu p$ = hole mobility

An estimate of the output voltage for a magnetic diode as shown in Figures 1 and 2 can be achieved by substituting the expression (9) into Equation (8). The result of this is as follows:

$$\Delta V = Ieo \, Wb/2Ln \, (\mu n/\mu p)B/NaqTb \operatorname{Coth}(Wb/Ln) \tag{10}$$

4

For short base length diodes, this reduces to the approximation given in expression (11):

$$\Delta V \quad leo(\mu n/\mu \ p) \ B/(2 \ NaqTb) \tag{11}$$

For long base length diodes, the expression can be approximated as shown in Equation (12).

$$\Delta V = leo \ Wb/2Ln \ (\mu n/\mu p) \ B/NaqTb \tag{12}$$

An expression can be derived for the voltage transduction efficiency $\Delta V/V$ which defines the ratio of magnetic signal sensitivity voltage to the quiescent DC diode voltage. The expression can be obtained directly from expression (8) by recognizing that leo/2 Rb will define the forward biased diode voltage drop. From expression (8) it can be found that:

$$\Delta V/V = W/Ln \ (\mu nB) \ Coth \ Wb/Ln \tag{13}$$

It is evident that the efficiency V/V for a given magnetic field B will depend upon the minority carrier mobility $\mu_n$, the emitter width W and the base length $W_b$. From expression (13), it may be observed that the efficiency does not depend on the depth $T_b$ of the base region or on its impurity concentration Na. However, the magnitude of the response signal $\Delta V$ does depend on these parameters as shown by expression (12). As a result, long base diodes will produce the best signal to noise property. It is most desirable to position the base contacts at least one minority carrier diffusion length $L_n$ away from the center of the emitter in order to minimize noise.

The sensitivity of a typical differential diode structure has been estimated assuming the following parameters and using the expression (8) above

leo = $20 \times 10^{-3}$ amps
W/Ln Coth Wb/Ln = 1
Rb = 1000
$\mu nB = .9 \times 10^{-5}$
$W_b = 3 \times 10^{-3}$ Cm
$L_n = 2 \times 10^3$ Cm

Utilizing the above assumptions the output voltage will be .09 millivolts per gauss. This sensitivity can be improved by increasing the base resistance, by operating at higher current levels, or both. A factor of five times approximate increase in sensitivity can be realized if the diode is constructed from P type gallium arsenide. This is true since the electron mobility $\mu$ for gallium arsenide is approximately five times that of the electron mobility in silicon which has been used in foregoing assumptions.

It is important to note that the use of load resistors $R_1$ greater in value than the base resistance of the diode structure should be employed. Otherwise, the signal voltage will be attenuated. It is preferred to energize the base contacts of the diode structure with current sources rather than resistors, but these facts would be evident to those of skill in the art.

Returning briefly to the figures, Figure 3 illustrates an alternative cross-section taken perpendicularly to the cross-section AA and indicated by the cross-section lines BB in Figure 1. In Figure 3, the $P^{++}$ injection suppressors 4 are seen to bound the sides of the emitter 2 so that the only primary area of injection that remains is the bottom surface of emitter 2 as previously described.

## Claims

1. A magnetically sensitive, differential diode structure, characterized in that it comprises an emitter (2) located in a base (3), an emitter contact (5) and at least two base contacts (6); said base (3) forming a PN junction with said emitter (2), said junction having edges and a bottom surface, and said base contacts (6) and said emitter contact (5) being supplied with electrical potential of proper polarity and magnitude to forward bias said PN junction to inject minority carriers from said emitter (2) into said base (3) and to withdraw such carriers at said base contacts (6); said diode structure further comprising injection suppressor areas (4) for inhibiting injection from said edges and for enhancing injection from said bottom surface, said bottom surface developing, in the presence of an externally applied magnetic field, a Lorentz potential having positive, null and negative values distributed across said bottom surface, said Lorentz potential modulating the injection of minority carriers from said bottom surface; and said base contacts (6) being positioned relative to said emitter (2) to lie on opposite sides of an imaginary plane constructed perpendicular to said bottom surface and passing through the null point of said Lorentz potential.

2. A diode structure according to claim 1, characterized in that said injection suppressor areas (4) comprise areas of material of more highly doped material of the same conductivity type as that of said base (2), said material being in said base and surrounding said emitter (2) except where said injection is desired.

**Patentansprüche**

1. Magnetisch empfindliche Differentialdiodenstruktur, dadurch gekennzeichnet, dass sie einen in einer Basis (3) befindlichen Emitter (2), einen Emitterkontakt (5) und zumindest zwei Basiskontakte (6) ehthält; wobei die genannte Basis (3) einen PN-Übergang mit dem genannten Emitter (2) bildet, wobei der genannte Übergang Kanten und eine untere Fläche aufweist und die genannten Basiskontakte (6) und der genannte Emitterkontakt (5) mit einem elektrischen Potential geeigneter Polarität und Grösse versorgt werden zur Vorspannung in Vorwärtsrichtung des genannten PN-Uebergangs, um Minoritätsladungsträger von dem genannten Emitter (2) in die genannte Basis (3) zu injizieren und derartige Ladungsträger an den genannten Basiskontakten (6) abzuziehen; wobei die genannte Diodenstruktur ferner Injektionsunterdrückungsbereiche (4) enthält zur Verzögerung der Injektion von den genannten Kanten und zur Verstärkung der Injektion von der genannten unteren Fläche, wobei in Anwesenheit eines aussen angelegten Magnetfeldes, ein Lorentzpotential entwickelt wird, welches positive Werte, Nullwerte und negative Werte aufweist, die quer durch die genannte untere Fläche hindurch verteilt sind, wobei das genannte Lorentzpotential die Injektion von Minoritätsladungsträgern von der genannten unteren Fläche moduliert; und wobei die genannten Basiskontakte (6) im Verhältnis zu dem genannten Emitter (2) derart angeordnet sind, dass sie sich auf den entgegengesetzten Seiten einer gedachten Ebene befinden, die rechtwinklig zu der genannten unteren Fläche aufgebaut ist, und den Nullpunkt des genannten Lorentzpotentials durchlaufen.

2. Diodenstruktur nach Anspruch 1, dadurch gekennzeichnet, dass die Injektionsunterdrückungsbereiche (4) Bereiche aus Material eines höher dotierten Materials vom gleichen Leitungstyp wie der der genannten Basis (2) enthalten, wobei das genannte Material in der genannten Basis ist und den genannten Emitter (2) umgibt, ausser dort, wo die genannte Injektion gewünscht wird.

**Revendications**

1. Structure de diode différentielle magnétiquement sensible, caractérisée en ce qu'elle comprend un émetteur (2) placé dans une base (3), un contact d'émetteur (5) et au moins deux contacts de base (6); ladite base (3) formant une jonction PN avec ledit émetteur (2), ladite jonction présentant des bords et une surface inférieure, et lesdits contacts de base (6) et ledit contact d'émetteur (5) étant alimentés avec un potentiel électrique de polarité et de grandeur appropriées pour la polarisation directe de ladite jonction PN de manière à injecter des porteurs minoritaires dudit émetteur (2) dans ladite base (3) et à extraire ces porteurs auxdits contacts de base (6); ladite structure de diode comprenant en outre des régions de suppresseur d'injection (4) pour inhiber l'injection à partir desdits bords et pour renforcer l'injection à partir de ladite surface inférieure, ladite surface inférieure développant, en présence d'un champ magnétique appliqué extérieurement, un potentiel de Lorentz ayant des valeurs positives, nulles et négatives, réparties sur ladite surface inférieure, ledit potentiel de Lorentz modulant l'injection de porteurs minoritaires à partir de ladite surface inférieure; et lesdits contacts de base (6) étant placés par rapport audit émetteur (2) de manière à se trouver sur des côtés opposés d'un plan imaginaire perpendiculaire à ladite surface inférieure et passant par le point zéro dudit potentiel de Lorentz.

2. Structure de diode suivant la revendication 1, caractérisée en ce que lesdites régions de suppresseur d'injection (4) comprennent des régions de matière plus fortement dopée du même type de conductivité que celui de ladite base (2), ladite matière étant dans ladite base et entourant ledit émetteur (2) sauf à l'endroit où ladite injection est désirée.

FIG. 1

FIG. 2

FIG. 3

1